(19) Europäisches Patentamt
European Patent Office
Office européen des brevets

(11) **EP 3 058 615 B1**

(12) **EUROPÄISCHE PATENTSCHRIFT**

(45) Veröffentlichungstag und Bekanntmachung des Hinweises auf die Patenterteilung:
**16.08.2017 Patentblatt 2017/33**

(21) Anmeldenummer: **14780886.9**

(22) Anmeldetag: **06.10.2014**

(51) Int Cl.:
*H01M 10/44* (2006.01)      *G01R 31/36* (2006.01)
*H02J 7/00* (2006.01)

(86) Internationale Anmeldenummer:
**PCT/EP2014/071361**

(87) Internationale Veröffentlichungsnummer:
**WO 2015/055454 (23.04.2015 Gazette 2015/16)**

(54) **VERFAHREN UND VORRICHTUNG ZUM EINSTELLEN EINER MAXIMAL-ENTLADETIEFE EINES ENERGIESPEICHERS FÜR EINE ZEITPERIODE**

METHOD AND DEVICE FOR SETTING A MAXIMUM DEPTH OF DISCHARGE OF AN ENERGY STORE FOR A TIME PERIOD

PROCÉDÉ ET DISPOSITIF PERMETTANT D'AJUSTER UNE PROFONDEUR DE DÉCHARGE MAXIMALE D'UN ACCUMULATEUR D'ÉNERGIE POUR UNE PÉRIODE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **18.10.2013 DE 102013221192**

(43) Veröffentlichungstag der Anmeldung:
**24.08.2016 Patentblatt 2016/34**

(73) Patentinhaber: **Robert Bosch GmbH**
**70442 Stuttgart (DE)**

(72) Erfinder: **SCHMIEGEL, Armin, Uwe**
**22609 Hamburg (DE)**

(56) Entgegenhaltungen:
**WO-A1-2011/035837      DE-A1-102007 038 586**

EP 3 058 615 B1

**Beschreibung**

Die vorliegende Erfindung betrifft ein Verfahren und eine Vorrichtung zum Einstellen einer Maximal-Entladetiefe eines Energiespeichers, insbesondere einer Batterie, für eine Zeitperiode.

Stand der Technik

Energiespeicher, insbesondere wiederaufladbare Batterien oder Akkumulatoren mit einer langen Lebensdauer, in welcher sie elektrische Leistung bereitstellen können, werden in zahlreichen Anwendungen benötigt. Die Lebensdauer einer Batterie wird im Wesentlichen durch zwei Effekte begrenzt: ein kalendarisches Altern der Batterie sowie eine Zyklenalterung der Batterie. Das kalendarische Altern der Batterie wird stark von dem mittleren Ladezustand (Englisch: state of charge, SOC) beeinflusst. Die Zyklenalterung der Batterie beruht auf dem regelmäßigen Be- und Entladen der Batterie. Eine wesentliche bestimmende Größe für die Zyklenalterung ist die Entladungstiefe oder Entladetiefe (Englisch: depth of discharge, DOD).

Üblicherweise wird eine Batterie so ausgelegt, dass bei einer mittleren Entladetiefe oder einem charakteristischen Be- und Entladeprofil eine bestimmte Lebensdauer erreicht wird. Als Lebensdauer wird beispielsweise jene Zeit definiert, bei der die Batterie 20 % ihrer ursprünglichen (Energiespeicher-)Kapazität verloren hat. Oft werden auch gewisse Sicherheitsmargen umgesetzt, welche sicherstellen sollen, dass die Lebensdauer auch wirklich erreicht wird.

Im Zusammenhang mit der Lebensdauer werden Alterungsmodelle verwendet, welche eine Alterung der Batterie charakterisieren. Entsprechend einem steigenden Batteriealter verringert sich der Gesundheitszustand (Englisch: state of health, SOH) der Batterie. Der Gesundheitszustand (SOH) wird üblicherweise als eine Zahl zwischen 1 (Beginn der Lebensdauer der Batterie) und 0 (Ende der Lebensdauer der Batterie) definiert.

Die DE 10 2007 038 586 A1 beschreibt ein Verfahren zur Lebensdauerüberwachung und optimalen Nutzung einer Batterie eines Hybridfahrzeugs. Die Batterie wird dabei innerhalb dynamisch vorgegebener Belastungsgrenzen belastet, wobei diese Belastungsgrenzen in Abhängigkeit vom Zustand und der bereits erfolgten Nutzung der Batterie errechnet werden. Das Berechnen basiert auf einem Stressindex, welcher basierend auf der Nutzung des Ladezustands der Batterie, der Temperatur der Batterie, der Spannung der Batterie und/oder der Spannung von einzelnen Zellen der Batterie basierend ermittelt wird.

Offenbarung der Erfindung

Die vorliegende Erfindung offenbart ein Verfahren mit den Merkmalen des Patentanspruchs 1 und eine Vorrichtung mit den Merkmalen des Patentanspruchs 9.

Demgemäß ist ein Verfahren zum Einstellen einer Maximal-Entladetiefe eines Energiespeichers für eine Zeitperiode vorgesehen, mit den Schritten: Festlegen eines ersten Soll-Alterungswerts des Energiespeichers für eine erste Zeitperiode; Bestimmen eines ersten Alterungswerts, welcher eine Alterung des Energiespeichers während der ersten Zeitperiode beschreibt; Berechnen einer ersten Differenz zwischen dem ersten Soll-Alterungswert des Energiespeichers und dem ersten Alterungswert des Energiespeichers; Festlegen eines zweiten Soll-Alterungswerts des Energiespeichers für eine zweite Zeitperiode; Berechnen eines Maximal-Alterungswerts des Energiespeichers für die zweite Zeitperiode, basierend auf dem zweiten Soll-Alterungswert und zumindest der ersten Differenz; Berechnen eines Maximal-Entladetiefe-Werts basierend auf dem Maximal-Alterungswert; Einstellen der Maximal-Entladetiefe des Energiespeichers für die zweite Zeitperiode auf den Maximal-Entladetiefe-Wert.

Weiterhin ist vorgesehen eine Vorrichtung zum Einstellen einer Maximal-Entladetiefe eines Energiespeichers für eine Zeitperiode mit einer Festlegungseinrichtung zum Festlegen eines ersten Soll-Alterungswerts des Energiespeichers für eine erste Zeitperiode und zum Festlegen eines zweiten Soll-Alterungswerts des Energiespeichers für eine zweite Zeitperiode. Die Vorrichtung umfasst weiterhin eine Alterungswert-Bestimmungseinrichtung zum Bestimmen eines ersten Alterungswerts, welcher eine Alterung des Energiespeichers während der ersten Zeitperiode beschreibt. Die Vorrichtung weist weiterhin eine Recheneinrichtung zum Berechnen einer ersten Differenz zwischen dem ersten Soll-Alterungswert des Energiespeichers und dem ersten Alterungswert des Energiespeichers, zum Berechnen eines Maximal-Alterungswerts des Energiespeichers für die zweite Zeitperiode, basierend auf dem zweiten Soll-Alterungswert und zumindest der ersten Differenz, und zum Berechnen eines Maximal-Entladetiefe-Werts basierend auf dem Maximal-Alterungswert auf. Ferner umfasst die Vorrichtung eine Einstelleinrichtung zum Einstellen der Maximal-Entladetiefe des Energiespeichers für die zweite Zeitperiode auf den Maximal-Entladetiefe-Wert.

Vorteile der Erfindung

Die der vorliegenden Erfindung zugrunde liegende Erkenntnis besteht darin, dass in einer bestimmten Zeitperiode der Lebensdauer eines Energiespeichers ein tatsächlicher Alterungswert des Energiespeichers unter einem Soll-Alterungswert des Energiespeichers für diese Zeitperiode liegen kann.

Sowohl der Soll-Alterungswert als auch der tatsächliche Alterungswert des Energiespeichers können basierend auf einem Alterungsmodell für den Energiespeicher berechnet werden. Für eine bestimmte vorgesehene Lebensdauer des Energiespeichers kann gemäß dem Alterungsmodell ein Soll-Alterungswert für einzelne Zeitperioden ermittelt werden. Altert der Energiespeicher während jeder Zeitperiode gemäß dem Soll-Alterungswert für diese Zeitperiode, so kann nach Ende der vorbestimmten Lebensdauer des Energiespeichers der Gesundheitszustand (SOH) des Energiespeichers Null betragen.

In realen Anwendungen wird es aber sehr häufig vorkommen, dass in einer bestimmten Zeitperiode der Energiespeicher weniger altert als es dem Soll-Alterungswert für diese Zeitperiode entspricht. Einerseits kann sich dadurch die Gesamtlebensdauer des Energiespeichers verlängern. Ist aber ohnehin nur die Benutzung des Energiespeichers bis zu der vorbestimmten Lebensdauer geplant, wird durch das unter dem Soll-Alterungswert liegende Altern des Energiespeichers in verschiedenen Zeitperioden Potential verschenkt. Das heißt, der Energiespeicher wird nicht optimal genutzt, sodass am Ende der geplanten Lebensdauer der Gesundheitszustand (SOH) des Energiespeichers nicht Null beträgt. In diesem Fall wurde der Energiespeicher also weniger ausgenutzt als es möglich gewesen wäre.

Die der vorliegenden Erfindung zugrunde liegende Idee besteht nun darin, dieser Erkenntnis Rechnung zu tragen und für eine Zeitperiode eine Maximal-Entladetiefe des Energiespeichers einzustellen. Die eingestellte Maximal-Entladetiefe berücksichtigt, dass in einigen oder allen oder auch nur der unmittelbar vorangehenden Zeitperiode die tatsächliche Alterung des Energiespeichers im Regelfall nicht dem Soll-Alterungswert für die Zeitperiode(n) entspricht.

Die Steuerung des Energiespeichers erfolgt erfindungsgemäß dynamisch an die tatsächlichen Gegebenheiten und Parameter des Energiespeichers angepasst, um den Ertrag über die Lebensdauer des Energiespeichers zu optimieren. Dadurch kann ein über die geplante Lebensdauer der Batterie erzielter Gesamt-Energiedurchsatz erhöht werden. Dies wiederum erlaubt das Ausbilden von verhältnismäßig kleineren Energiespeichern bei gleich bleibendem gewünschtem Gesamt-Energiedurchsatz. Mit dem erfindungsgemäßen Verfahren kann auch für jede Zeitperiode in der Lebensdauer des Energiespeichers eine Maximal-Entladetiefe dynamisch eingestellt werden.

Der Energiespeicher kann eine Batterie sein, beispielsweise eine Batterie zum Speichern von mittels erneuerbaren Energien erzeugter elektrischer Energie oder einer Batterie in einem Elektro- oder Hybridfahrzeug. Bei dem Energiespeicher kann es sich aber beispielsweise auch um einen Stausee eines Pumpspeicherkraftwerks handeln.

Die erfindungsgemäße Vorrichtung kann beispielsweise in oder an einem Batterie-Laderegler einer Batterie als Energiespeicher ausgebildet sein. Das Einstellen der Maximal-Entladetiefe der Batterie für eine bestimmte Zeitperiode auf einen Maximal-Entladetiefe-Wert bedeutet in diesem Fall, dass der Batterie-Laderegler die Batterie innerhalb der zweiten Zeitperiode nur bis zu diesem Maximal-Entladetiefe-Wert entladen darf. Ist die Batterie bereits bis zu diesem Wert entladen, verweigert der Batterie-Laderegler eine weitere Energieentnahme aus der Batterie, bevor diese - zumindest teilweise - wieder aufgeladen wurde.

Vorteilhafte Ausführungsformen und Weiterbildungen ergeben sich aus den Unteransprüchen sowie aus der Beschreibung unter Bezugnahme auf die Figuren.

Gemäß einer bevorzugten Weiterbildung des erfindungsgemäßen Verfahren sind der erste Soll-Alterungswert $a_{soll,1}$ und der zweite Soll-Alterungswert $a_{soll,2}$ gleich einem konstanten globalen Soll-Alterungswert $a_{soll}$. Der Soll-Alterungswert kann auch für jede Zeitperiode während der Lebensdauer der Batterie gleich sein und dem globalen Soll-Alterungswert $a_{soll}$ entsprechen. Der globale Soll-Alterungswert $a_{soll}$ kann beispielsweise auf der Art des Energiespeichers und/oder auf dessen Aufstellungsort, oder einer gewünschten Zielgröße, beispielsweise einer geplanten Lebensdauer, einer geplanten Gesamt-Zyklenzahl und/oder einem geplanten Gesamt-Energiedurchsatz basieren.

Gemäß einer weiteren bevorzugten Weiterbildung können der erste Soll-Alterungswert $a_{soll,1}$ und/oder der zweite Soll-Alterungswert $a_{soll,2}$ regelmäßig basierend auf einem Kalenderdatum eingestellt oder modifiziert werden. Beispielsweise können im Sommer höhere Entladetiefen DOD zugelassen werden als im Winter, etwa falls der Energiespeicher zum Speichern von Energie vorgesehen ist, welche basierend auf Solarenergie erzeugt wird. Im Sommer ist der Speicherbedarf solcher Energiespeicher üblicherweise höher als im Winter, da es mehr Sonnenstunden pro Tag gibt. Entsprechend können Soll-Alterungswerte für Zeitperioden an Kalenderdaten, an denen statistisch mehr Sonnenstunden pro Tag auftreten, höher angesetzt werden als Soll-Alterungswerte für Zeitperioden an Kalendertagen, an denen statistisch weniger Sonnenstunden auftreten.

Auch andere externe Größen können für das Festlegen der variablen oder konstanten Soll-Alterungswerte eine Rolle spielen, etwa eine Umgebungstemperatur, eine Regenwahrscheinlichkeit oder eine Luftfeuchtigkeit an einem bestimmten Ort, je nach verwendetem Energiespeicher und je nach mit dem Energiespeicher verbundenen Verbrauchern oder Energieerzeugern, beispielsweise Solar-, Wind- oder Wasserkraftwerke.

Das Festlegen der Soll-Alterungswerte $a_{soll,1}$, $a_{soll,2}$ kann auch basierend auf zeit- und ortsabhängigen Wettervorhersagen erfolgen. Beispielsweise können, falls eine Wettervorhersage für den Standort einer Solarzellenanlage mit angeschlossenem Energiespeicher für einen bestimmten Zeitraum besonders viel Sonneneinstrahlung vorhersagt, Soll-Alterungswerte für Zeitperioden innerhalb dieses bestimmten Zeitraums höher ausfallen als Soll-Alterungswerte für Zeitperioden innerhalb von Zeiträumen mit weniger Sonneneinstrahlung.

Das Festlegen der Soll-Alterungswerte $a_{soll,1}$, $a_{soll,2}$ kann auch basierend auf einer internalisierten Modellbildung erfolgen. Beispielsweise kann durch eine Sensorik festgestellt werden, dass in einem bestimmten Muster regelmäßig Zeiträume mit mehr Energie- oder Speicherbedarf und Zeiträume mit weniger Energie- oder Speicherbedarf auftreten. Solche Muster können etwa im Tages-, Wochen-, Monats- oder Jahresrhythmus auftreten. Wiederholt sich das Muster mit einer bestimmten Mindestzuverlässigkeit, können die Soll-Alterungswerte für die Zeitperioden entsprechend dem bestimmten Muster festgelegt werden.

Gemäß einer weiteren bevorzugten Weiterbildung umfasst dabei das Verfahren den Schritt: Bestimmen jeweils einer Entladetiefe des Energiespeichers für alle Entladezyklen während der ersten Zeitperiode; wobei der erste Alterungswert $a_1$ unter Verwendung eines Alterungsmodells basierend auf den bestimmten Entladetiefen berechnet wird. Da die Entladetiefe einen wesentlichen Einfluss auf die Zyklenalterung hat, kann auf diese Weise der erste Alterungswert $a_1$ bzw. jeder Alterungswert $a_i$ für eine beliebige i-te Zeitperiode besonders genau angenähert bzw. berechnet werden.

Gemäß einer weiteren bevorzugten Weiterbildung wird der erste Alterungswert $a_1$ basierend auf einer mittleren Entladetiefe berechnet, wobei die mittlere Entladetiefe der Mittelwert der bestimmten Entladetiefen der Entladezyklen während der ersten Zeitperiode ist. Entsprechend kann auch jeder Alterungswert $a_i$ für jede i-te Zeitperiode basierend auf einer mittleren Entladetiefe als Mittelwert der Entladetiefen der Entladezyklen während der i-ten Zeitperiode bestimmt werden. Die Berechnung des Mittelwerts kann als gleichgewichteter Mittelwert erfolgen.

Verschiedene Entladetiefen können aber auch ungleich gewichtet zur Mittelwertbildung herangezogen werden, etwa falls bekannt ist, dass eine Entladetiefe über oder unter einer bestimmten Schwelle den Energiespeicher besonders stark oder besonders wenig strapaziert, das heißt altern lässt. Eine bestimmte Entladetiefe, welche den Energiespeicher besonders stark altern lässt, kann in dem Mittelwert verhältnismäßig stärker gewichtet werden als eine bestimmte Entladetiefe, welche den Energiespeicher besonders wenig altern lässt.

Gemäß einer weiteren bevorzugten Weiterbildung ist die zweite Zeitperiode eine Zeitperiode, welche zeitlich unmittelbar auf die erste Zeitperiode nachfolgt.

Gemäß einer weiteren bevorzugten Weiterbildung wird das Verfahren für jede einer Mehrzahl von unmittelbar aufeinanderfolgenden Zeitperioden als jeweilige zweite Zeitperiode durchgeführt, wobei als der jeweilige erste Soll-Alterungswert $a_{soll,1}$ der ersten Periode der berechnete Maximal-Alterungswert $A_1$ für die jeweils unmittelbar vorangehende Zeitperiode festgelegt wird. Das Verfahren kann somit für eine Vielzahl von Zeitperioden iterativ wiederholt durchgeführt werden. Dabei kann etwa jeweils die bei der i-ten Wiederholung als "zweite Zeitperiode" betrachtete Zeitperiode bei der (i+1)-ten Wiederholung als "erste Zeitperiode" betrachtet werden und bei der (i+1)-ten Wiederholung weiterhin eine Zeitperiode, welche der "zweiten Zeitperiode" der i-ten Wiederholung unmittelbar nachfolgt, als "zweite Zeitperiode" der (i+1)-ten Wiederholung sowie als "erste Zeitperiode" der (i+2)-ten Wiederholung betrachtet werden, und so weiter.

Gemäß einer weiteren bevorzugten Weiterbildung des erfindungsgemäßen Verfahrens wird weiterhin eine Mehrzahl von weiteren Differenzen $\Delta_i$ berechnet. Jede weitere i-te Differenz $\Delta_i$ ist eine Differenz zwischen einem i-ten Soll-Alterungswert $a_{soll,i}$ des Energiespeichers und jeweils einem bestimmten i-ten Alterungswert $a_i$, welcher eine Alterung des Energiespeichers während einer i-ten Zeitperiode beschreibt. Das Berechnen des Maximal-Alterungswerts $A_2$ des Energiespeichers für die zweite Zeitperiode kann weiterhin auf den berechneten weiteren Differenzen $\Delta_i$ basieren.

## KURZE BESCHREIBUNG DER ZEICHNUNGEN

Die vorliegende Erfindung wird nachfolgend anhand der in den schematischen Figuren der Zeichnungen dargestellten Ausführungsbeispiele näher erläutert. Es zeigen:

Fig. 1    ein schematisches Blockdiagramm zum Erläutern einer Vorrichtung zum Einstellen einer Maximal-Entladetiefe eines Energiespeichers für eine Zeitperiode gemäß einer ersten Ausführungsform der vorliegenden Erfindung; und

Fig. 2    ein schematisches Flussdiagramm zum Erläutern eines Verfahrens zum Einstellen einer Maximal-Entladetiefe eines Energiespeichers für eine Zeitperiode gemäß einer zweiten Ausführungsform der vorliegenden Erfindung.

## BESCHREIBUNG DER AUSFÜHRUNGSBEISPIELE

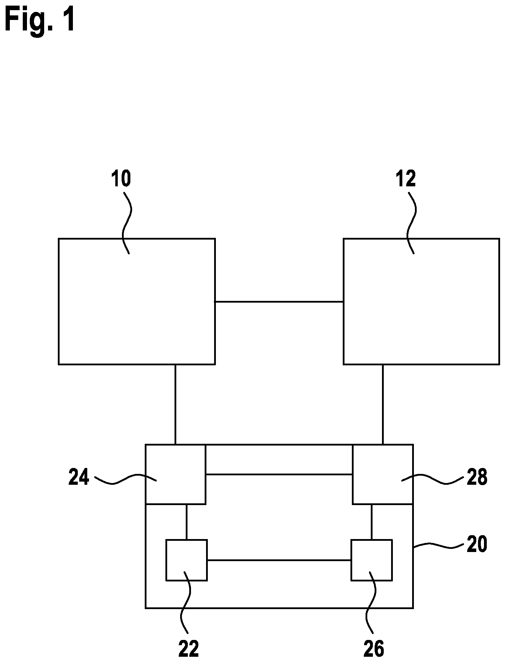

Fig. 1 zeigt ein schematisches Blockdiagramm zum Erläutern einer Vorrichtung zum Einstellen einer Maximal-Entladetiefe eines Energiespeichers für eine Zeitperiode gemäß einer ersten Ausführungsform der vorliegenden Erfindung.

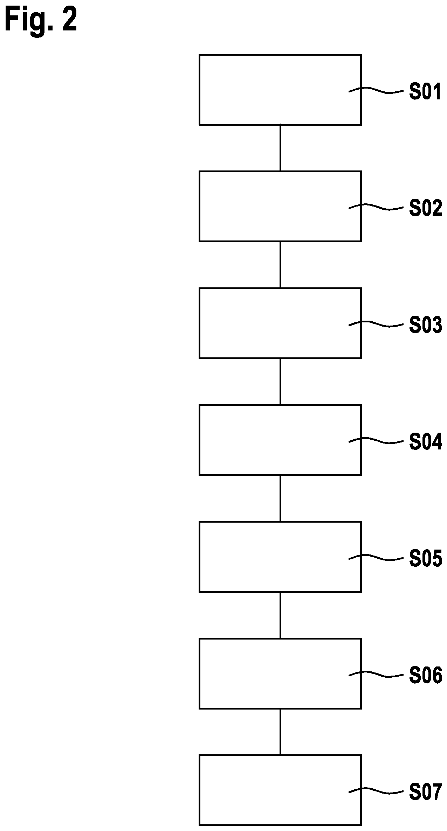

Gemäß Fig. 1 umfasst die Vorrichtung zum Einstellen einer Maximal-Entladetiefe eines Energiespeichers für eine Zeitperiode gemäß der ersten Ausführungsform der vorliegenden Erfindung eine Festlegungseinrichtung 22, eine Alterungswert-Bestimmungseinrichtung 24, eine Recheneinrichtung 26 und eine Einstelleinrichtung 28, welche miteinander gekoppelt sind. Zumindest die Alterungswert-Bestimmungseinrichtung 24 ist mit dem Energiespeicher 10 gekoppelt. Zumindest die Einstelleinrichtung 28 ist mit einem Batterie-Laderegler 12 gekoppelt. Der Batterie-Laderegler 12 ist mit dem Energiespeicher 10 gekoppelt und steuert/regelt das Be-/Entladen des Energiespeichers 10. Insbesondere kann der Batterie-Laderegler 12 einstellen, bis zu welcher Entladetiefe der Energiespeicher 10 in einer bestimmte Zeitperiode entladen werden darf. Die Funktionen der in Fig. 1 gezeigten Elemente werden im Folgenden unter Bezugnahme auf Fig. 2 näher erläutert.

Figur 2 zeigt ein schematisches Flussdiagramm zum Erläutern eines Verfahrens zum Einstellen einer Maximal-Entladetiefe eines Energiespeichers für eine Zeitperiode gemäß einer zweiten Ausführungsform der vorliegenden Erfindung.

In einem Verfahrensschritt S01 wird ein erster Soll-Alterungswert $a_{soll,1}$ des Energiespeichers 10 für eine erste Zeitperiode festgelegt, beispielsweise mittels der Festlegungseinrichtung 22. Gemäß der zweiten Ausführungsform werden Zeitperioden von der Dauer von einem Tag angenommen. Für das Festlegen des ersten Soll-Alterungswerts $a_{soll,1}$ wird die geplante Lebensdauer des Energiespeichers 10 durch die Dauer der ersten Zeitperiode, in diesem Fall einem Tag, geteilt. Der Kehrwert der ermittelten Zahl ist der Bruchteil des Gesundheitszustands SOH der Batterie 10, um welchen der Gesundheitszustand SOH in jeder Zeitperiode planmäßig verringert werden darf, also der erste Soll-Alterungswert $a_{soll,1}$. Würde der Energiespeicher 10 also in jeder Zeitperiode seiner Lebensdauer um den ersten Soll-Alterungswert $a_{soll,1}$ altern, hätte sich der Gesundheitszustand SOH der Batterie 10 von 1 am Anfang der Lebensdauer auf 0 am Ende der Lebensdauer verringert, entsprechend der Formel $SOH = 1 - \Sigma_i\, a_{soll,i}$. Zur Beschreibung der zweiten Ausführungsform wird im Folgenden von einer Batterie 10 als Energiespeicher 10 ausgegangen.

Gemäß der zweiten Ausführungsform wird als Alterungsmodell für die Batterie 10 ein Polynom zweiten Grades in der mittleren Entladungstiefe pro Zeitperiode verwendet, das heißt

$$a_i = c_1 d_i + c_2 d^2_i.$$

Dabei ist $a_i$ ein i-ter Alterungswert der Batterie 10 während einer i-ten Zeitperiode, $d_i$ eine mittlere Entladetiefe der Batterie 10 über mehrere Be- und Entladezyklen während der i-ten Zeitperiode und $c_1$, $c_2$ freie Parameter, welche geeignet festgelegt werden können. Der tatsächliche Alterungszustand bzw. "state of health" SOH der Batterie 10 ist also durch $SOH = 1 - \Sigma_i a_i$ gegeben. Statt eines Polynoms zweiten Grades ist auch das Verwenden von Polynomen höheren Grades möglich, um ein noch genaueres Alterungsmodell zu ermöglichen. Die Koeffizienten $c_1$, $c_2$, ..., $c_p$ des Alterungsmodells werden vorteilhafterweise basierend auf Messungen bestimmt.

Ausgehend von diesem Alterungsmodell kann alternativ auch der erste Soll-Alterungswert $a_{soll,1}$ basierend auf einer gewünschten mittleren Entladetiefe pro Zeitperiode festgelegt werden. Ist beispielsweise im Durchschnitt eine mittlere Entladetiefe von 60 % vorteilhaft, kann als erster Soll-Alterungswert $a_{soll,1}$ etwa

$$a_{Soll,1} = c_1 60 + c_2 60^2$$

festgelegt werden.

In einem Schritt S02 wird ein erster Alterungswert $a_1$ bestimmt, welcher eine Alterung der Batterie 10 während der ersten Zeitperiode beschreibt, etwa mittels der Alterungswert-Bestimmungseinrichtung 24. Gemäß der zweiten Ausführungsform werden dazu alle Entladetiefen der Batterie 10 für alle Entladezyklen während der ersten Zeitperiode bestimmt. Aus den bestimmten Entladetiefen, welche jeweils die Entladung der Batterie 10, bezogen auf ihre Gesamtkapazität, angeben, wird durch gleichgewichtete Mittelwertbildung eine mittlere Entladetiefe während der ersten Zeitperiode berechnet. Mittels des oben beschriebenen Alterungsmodells kann somit der erste Alterungswert $a_1$, welcher die Alterung der Batterie 10 während der ersten Zeitperiode beschreibt, bestimmt werden. Das zum Bestimmen des ersten Alterungswerts $a_1$ verwendete Modell kann auch, im Vergleich zu dem oben beschriebenen Modell, von der Form

$$a_i = \gamma\,(c_1 d_i + c_2 d^2_i)$$

sein, wobei $\gamma$ ein Kontrollparameter zwischen 0 und 1 ist. Der Kontrollparameter $\gamma$ kann die Empfindlichkeit eines Reglers anpassen und/oder dazu dienen, eventuelle Fehler im Alterungsmodell zu kompensieren.

In einem Schritt S03 wird eine erste Differenz $\Delta_1$ zwischen dem ersten Soll-Alterungswert $a_{soll,1}$ der Batterie 10 und dem ersten Alterungswert $A_1$ der Batterie 10 berechnet, etwa mittels der Recheneinrichtung 26. Mit anderen Worten,

$$\Delta_1 = a_{Soll,1} - a_1.$$

Die erste Differenz $\Delta_1$ beschreibt sozusagen das "Alterungs-Guthaben" falls $\Delta_1$ positiv ist oder eine "Alterungs-Schuld", falls $\Delta_1$ negativ ist. Gemäß der zweiten Ausführungsform kann die Alterungs-Schuld oder das Alterungs-Guthaben einer Zeitperiode auf eine nachfolgende Zeitperiode übertragen werden.

In einem Verfahrensschritt S04 wird ein zweiter Soll-Alterungswert $a_{soll,2}$ der Batterie 10 für eine zweite Zeitperiode festgelegt, etwa mittels der Festlegungseinrichtung 22. Gemäß der zweiten Ausführungsform ist der zweite Soll-Alterungswert $a_{soll,2}$ gleich dem ersten Soll-Alterungswert $a_{soll,1}$ und die zweite Zeitperiode ist eine unmittelbar auf die erste Zeitperiode nachfolgende Zeitperiode.

In einem Schritt S05 wird ein Maximal-Alterungswert $A_2$ der Batterie 10 für die zweite Zeitperiode berechnet, etwa mittels der Recheneinrichtung 26. Dieser Maximal-Alterungswert $A_2$ basiert auf dem zweiten Soll-Alterungswert $a_{soll,2}$ und zumindest der ersten Differenz $\Delta_1$. Gemäß der zweiten Ausführungsform ist der Maximal-Alterungswert $A_2$ die Summe aus dem zweiten Soll-Alterungswert $a_{soll,2}$ und der ersten Differenz $\Delta_1$, das

heißt

$$A_2 = a_{Soll,2} + \Delta_1.$$

Gemäß einer dritten Ausführungsform, welche im Wesentlichen analog zu der zweiten Ausführungsform ist, wird nicht nur die erste Differenz $\Delta_1$ zwischen dem ersten Soll-Alterungswert $a_{soll,1}$ und dem ersten Alterungswert A, der Batterie 10 bestimmt, sondern es wird eine Vielzahl von weiteren Differenzen $\Delta_i$ zwischen i-ten Soll-Alterungswerten $a_{soll,i}$ der Batterie 10 und i-ten Alterungswerten $A_i$ der Batterie 10 auf die gleiche Weise bestimmt wie oben für die erste Differenz $\Delta_1$ beschrieben. Weiterhin wird gemäß dieser Ausführungsform der Maximal-Alterungswert $\Delta_2$ für die zweite Zeitperiode als Summe des zweiten Soll-Alterungswerts $a_{soll,2}$ und aller berechneten i-ten Differenzen $\Delta_i$ für alle Zeitperioden, welche vor der zweiten Zeitperiode lagen, berechnet, das heißt $A_2 = a_{soll,2} + \sum_{i=1,i\neq2}^{n} \Delta_i$, wobei die n-te Zeitperiode die unmittelbar vor der zweiten Zeitperiode vorangehende Zeitperiode ist. Allgemein kann für den Maximal-Alterungswert Am einer m-ten Zeitperiode gelten:

$$A_m = a_{soll,m} + \sum_{i=1}^{m-1} \Delta_i.$$

Mit anderen Worten kann gemäß dieser Ausführungsform der vorliegenden Erfindung ein Alterungs-Guthaben oder eine Alterungs-Schuld von Zeitperiode zu Zeitperiode unbegrenzt weitergegeben werden. Optional kann ein Limit gesetzt werden, dass beispielsweise nur die jeweils fünf letzten Alterungs-Guthaben/Schulden, d.h. Differenzen $\Delta_{i-5}$ bis $\Delta_{i-1}$ zur Bestimmung des Maximal-Alterungswerts $A_i$ für die i-te Zeitperiode herangezogen werden. Es kann auch ein absolutes Limit für den Maximal-Alterungswert $A_i$ aller Zeitperioden festgelegt werden, um Extremwerte zu vermeiden. Ebenso kann auch das von jeder einzelnen Zeitperiode übertragbare Alterungs-Guthaben/Schuld auf ein Limit L limitiert werden, das heißt $\Delta_i \leq L$.

In einem Verfahrensschritt S06 wird basierend auf dem Maximal-Alterungswert $A_2$ ein Maximal-Entladetiefe-Wert $D_2$ für die zweite Zeitperiode berechnet, etwa mittels der Recheneinrichtung 26. Gemäß der zweiten Ausführungsform wird der Maximal-Entladetiefe-Wert $D_i$ für die i-te Zeitperiode unter Verwendung des oben beschriebenen Alterungsmodells berechnet. Dazu wird der berechnete Maximal-Alterungswert $A_i$ mit der Formel für den Alterungswert $a_i$ der i-ten Zeitperiode gemäß dem Alterungsmodell gleichgesetzt, und statt der bekannten mittleren Entladetiefe $d_i$ wird der zu bestimmende Maximal-Entladetiefe-Wert $D_i$ bzw. $D_2$ eingesetzt:

$$A_i = c_1 D_i + c_2 D_i{}^2$$

bzw.

$$A_2 = c_1 D_2 + c_2 D_2{}^2.$$

Die entstehende Gleichung wird dann nach dem Maximal-Entladetiefe-Wert $D_i$ für die i-te Zeitperiode bzw. dem Maximal-Entladetiefe-Wert $D_2$ für die zweite Zeitperiode aufgelöst. Das heißt, ein und dasselbe Alterungsmodell wird sowohl zum Berechnen des tatsächlichen Alterungswerts $a_i$ der i-ten Zeitperiode als auch zum Berechnen S05 des Maximal-Alterungswerts $A_{i+1}$ der (i+1)-ten Zeitperiode verwendet. Alternativ können für die beiden Berechnungen auch unterschiedliche Alterungsmodelle verwendet werden.

In einem Verfahrensschritt S07 wird die Maximal-Entladetiefe der Batterie 10 für die zweite Zeitperiode auf den Maximal-Entladetiefe-Wert $D_2$ eingestellt. Dies kann beispielsweise durch eine an der Batterie 10 oder an dem Batterie-Laderegler 12 ausgebildete erfindungsgemäße Vorrichtung 20 erfolgen, insbesondere durch die Einstelleinrichtung 28. In jedem Fall kann die Batterie 10 in der zweiten Zeitperiode nur maximal bis zu dem eingestellten Maximal-Entladetiefe-Wert $D_2$ entladen werden.

Obwohl die vorliegende Erfindung anhand bevorzugter Ausführungsbeispiele vorstehend beschrieben wurde, ist sie darauf nicht beschränkt, sondern auf vielfältige Art und Weise modifizierbar. Insbesondere lässt sich die Erfindung in mannigfaltiger Weise verändern oder modifizieren, ohne vom Kern der Erfindung abzuweichen.

Beispielsweise können selbstverständlich Zeitperioden von anderer Periodendauer als einem Tag verwendet werden. Je nach Verwendung und Umgebung des Energiespeichers kann es sich dabei etwa um Minuten, Stunden, Wochen, Monate, oder auch weitere Periodendauern handeln, beispielsweise Periodendauern von 3 Tagen.

Gemäß den vorbeschriebenen Ausführungsformen waren die Zeitperioden stets gleich lang. Es ist aber auch denkbar, dass die Zeitperioden variabel bestimmt werden, beispielsweise dass je eine Zeitperiode den Zeitraum umfasst, in welchem ein einzelner Beladezyklus und ein einzelner Entladezyklus des Energiespeichers durchgeführt wird. Dies kann beispielsweise vorteilhaft sein, wenn statt einer geplanten Lebensdauer des Energiespeichers eine geplante Anzahl von Be-/Entladezyklen des Energiespeichers vorbestimmt werden soll. Das Verfahren mit den variablen Zeitperioden könnte analog zu einer der oben beschriebenen Ausführungsformen erfolgen, wobei ein globaler konstanter Soll-Alterungswert $a_{soll}$ für alle Zeitperioden durch den Kehrwert der vorbestimmten Gesamtzyklenzahl sein kann.

Unter einer Vorrichtung kann vorliegend ein elektrisches Gerät verstanden werden, das Sensorsignale verarbeitet und in Abhängigkeit davon Steuer- und/oder Datensignale ausgibt. Die Vorrichtung kann eine Schnittstelle aufweisen, die hard- und/oder softwaremäßig ausgebildet sein kann. Bei einer hardwaremäßigen Ausbildung können die Schnittstellen beispielsweise Teil eines sogenannten System-ASICs sein, der verschiedenste Funktionen der Vorrichtung beinhaltet. Es ist jedoch auch möglich, dass die Schnittstellen eigene, integrierte Schaltkreise sind oder zumindest teilweise aus diskreten Bauelementen bestehen. Bei einer softwaremäßigen Ausbildung können die Schnittstellen Softwaremodule sein, die beispielsweise auf einem Mikrocontroller neben anderen Softwaremodulen vorhanden sind.

**Patentansprüche**

1. Verfahren zum Einstellen einer Maximal-Entladetiefe eines Energiespeichers (10) für eine Zeitperiode mit den Schritten:

Festlegen (S01) eines ersten Soll-Alterungswerts $a_{soll,1}$ des Energiespeichers (10) für eine erste Zeitperiode;
Bestimmen (S02) eines ersten Alterungswerts $a_1$, welcher eine Alterung des Energiespeichers (10) während der ersten Zeitperiode beschreibt;
Berechnen (S03) einer ersten Differenz $\Delta_1$ zwischen dem ersten Soll-Alterungswert $a_{soll,1}$ des Energiespeichers (10) und dem ersten Alterungswert $a_1$ des Energiespeichers (10);
Festlegen (S04) eines zweiten Soll-Alterungswerts $a_{soll,2}$ des Energiespeichers (10) für eine zweite Zeitperiode;
Berechnen (S05) eines Maximal-Alterungswerts $A_2$ des Energiespeichers (10) für die zweite Zeitperiode, basierend auf dem zweiten Soll-Alterungswert $a_{soll,2}$ und zumindest der ersten Differenz $\Delta_1$;
Berechnen (S06) eines Maximal-Entladetiefe-Werts $D_1$ basierend auf dem Maximal-Alterungswert $A_2$;
Einstellen (S07) der Maximal-Entladetiefe des Energiespeichers (10) für die zweite Zeitperiode auf den Maximal-Entladetiefe-Wert $D_1$.

2. Verfahren nach Anspruch 1, wobei der erste Soll-Alterungswert $a_{soll,1}$ und der zweite Soll-Alterungswert $a_{soll,2}$ ein konstanter globaler Soll-Alterungswert $a_{soll}$ sind.

3. Verfahren nach Anspruch 1, wobei der erste Soll-Alterungswert $a_{soll,1}$ und/oder der zweite Soll-Alterungswert $a_{soll,1}$ regelmäßig basierend auf einem Kalenderdatum eingestellt oder modifiziert werden.

4. Verfahren nach einem der vorangehenden Ansprüche 1 bis 3,

wobei das Verfahren den Schritt umfasst:

Bestimmen jeweils einer Entladetiefe des Energiespeichers (10) für alle Entladezyklen während der ersten Zeitperiode;
wobei der erste Alterungswert $a_1$ unter Verwendung eines Alterungsmodells basierend auf den bestimmten Entladetiefen berechnet wird.

5. Verfahren nach Anspruch 4,
wobei der erste Alterungswert a1 basierend auf einer mittleren Entladetiefe berechnet wird, wobei die mittlere Entladetiefe der Mittelwert der bestimmten Entladetiefen der Entladezyklen während der ersten Zeitperiode ist.

6. Verfahren nach einem der vorangehenden Ansprüche 1 bis 5, wobei die zweite Zeitperiode zeitlich unmittelbar auf die erste Zeitperiode nachfolgt.

7. Verfahren nach Anspruch 6, wobei das Verfahren für jede einer Mehrzahl von unmittelbar aufeinanderfolgenden Zeitperioden als jeweilige zweite Zeitperiode durchgeführt wird, wobei der jeweilige erste Soll-Alterungswert $a_{soll,1}$ der ersten Periode der berechnete (S05) Maximal-Alterungswert $A_1$ für die jeweils unmittelbar vorangehende Zeitperiode ist.

8. Verfahren nach einem der vorangehenden Ansprüche 1 bis 7, wobei weiterhin eine Mehrzahl von weiteren Differenzen $\Delta_i$ berechnet wird, wobei jede weitere i-te Differenz $\Delta_i$ eine Differenz zwischen einem i-ten Soll-Alterungswert $a_{soll,i}$ des Energiespeichers (10) und jeweils einem bestimmten i-ten Alterungswert ai, welcher eine Alterung des Energiespeichers (10) während einer i-ten Zeitperiode beschreibt, ist; und
wobei das Berechnen des Maximal-Alterungswerts $A_2$ des Energiespeichers (10) für die zweite Zeitperiode weiterhin auf den berechneten weiteren Differenzen $\Delta_i$ basiert.

9. Vorrichtung zum Einstellen einer Maximal-Entladetiefe eines Energiespeichers für eine Zeitperiode mit:

einer Festlegungseinrichtung (22) zum Festlegen (S01) eines ersten Soll-Alterungswerts $a_{soll,1}$ des Energiespeichers (10) für eine erste Zeitperiode und zum Festlegen (S04) eines zweiten Soll-Alterungswerts $a_{soll,2}$ des Energiespeichers (10) für eine zweite Zeitperiode;
einer Alterungswert-Bestimmungseinrichtung (24) zum Bestimmen (S02) eines ersten Alterungswerts $a_1$, welcher eine Alterung des Energiespeichers (10) während der ersten Zeitperiode beschreibt;
einer Recheneinrichtung (26)
zum Berechnen (S03) einer ersten Differenz $\Delta_1$

zwischen dem ersten Soll-Alterungswert $a_{soll,1}$ des Energiespeichers (10) und dem ersten Alterungswert $a_1$ des Energiespeichers (10), zum Berechnen (S05) eines Maximal-Alterungswerts $A_2$ des Energiespeichers (10) für die zweite Zeitperiode, basierend auf dem zweiten Soll-Alterungswert $a_{soll,2}$ und zumindest der ersten Differenz $\Delta_1$, und

zum Berechnen (S06) eines Maximal-Entladetiefe-Werts $D_1$ basierend auf dem Maximal-Alterungswert $A_2$; und

einer Einstelleinrichtung (28) zum Einstellen (S07) der Maximal-Entladetiefe des Energiespeichers für die zweite Zeitperiode auf den Maximal-Entladetiefe-Wert $D_1$.

**Claims**

1. Method for setting a maximum discharge depth of an energy store (10) for a time period, having the steps of:

   stipulating (S01) a first desired ageing value $a_{soll,1}$ of the energy store (10) for a first time period;

   determining (S02) a first ageing value $a_1$ which describes ageing of the energy store (10) during the first time period;

   calculating (S03) a first difference $\Delta_1$ between the first desired ageing value $a_{soll,1}$ of the energy store (10) and the first ageing value $a_1$ of the energy store (10);

   stipulating (S04) a second desired ageing value $a_{soll,2}$ of the energy store (10) for a second time period;

   calculating (S05) a maximum ageing value $A_2$ of the energy store (10) for the second time period on the basis of the second desired ageing value $a_{soll,2}$ and at least the first difference $\Delta_1$;

   calculating (S06) a maximum discharge depth value $D_1$ on the basis of the maximum ageing value $A_2$;

   setting (S07) the maximum discharge depth of the energy store (10) for the second time period to the maximum discharge depth value $D_1$.

2. Method according to Claim 1, the first desired ageing value $a_{soll,1}$ and the second desired ageing value $a_{soll,2}$ being a constant global desired ageing value $a_{soll}$.

3. Method according to Claim 1, the first desired ageing value $a_{soll,1}$ and/or the second desired ageing value $a_{soll,2}$ regularly being set or modified on the basis of a calendar date.

4. Method according to one of the preceding Claims 1 to 3,
   the method comprising the step of:

   determining a respective discharge depth of the energy store (10) for all discharge cycles during the first time period;

   the first ageing value $a_1$ being calculated using an ageing model on the basis of the determined discharge depths.

5. Method according to Claim 4,
   the first ageing value a1 being calculated on the basis of an average discharge depth, the average discharge depth being the average value of the determined discharge depths of the discharge cycles during the first time period.

6. Method according to one of the preceding Claims 1 to 5, the second time period immediately following the first time period in terms of time.

7. Method according to Claim 6, the method being carried out for each of a plurality of immediately successive time periods as a respective second time period, the respective first desired ageing value $a_{soll,1}$ of the first period being the calculated (S05) maximum ageing value $A_1$ for the respective immediately preceding time period.

8. Method according to one of the preceding Claims 1 to 7, a plurality of further differences $\Delta_i$ also being calculated, each further i-th difference $\Delta_i$ being a difference between an i-th desired ageing value $a_{soll,1}$ of the energy store (10) and a respective determined i-th ageing value ai which describes ageing of the energy store (10) during an i-th time period; and
   the calculation of the maximum ageing value $A_2$ of the energy store (10) for the second time period also being based on the calculated further differences $\Delta_i$.

9. Apparatus for setting a maximum discharge depth of an energy store for a time period, having:

   a stipulation device (22) for stipulating (S01) a first desired ageing value $a_{soll,1}$ of the energy store (10) for a first time period and for stipulating (S04) a second desired ageing value $a_{soll,2}$ of the energy store (10) for a second time period;

   an ageing value determination device (24) for determining (S02) a first ageing value $a_1$ which describes ageing of the energy store (10) during the first time period;

   a computation device (26)
   for calculating (S03) a first difference $\Delta_1$ between the first desired ageing value $a_{soll,1}$ of the energy store (10) and the first ageing value $a_1$ of the energy store (10), for calculating (S05) a maximum ageing value $A_2$ of the energy store (10) for the second time period on the basis of the second desired ageing value $a_{soll,2}$ and at least the first difference $\Delta_1$, and

for calculating (S06) a maximum discharge depth value $D_1$ on the basis of the maximum ageing value $A_2$; and

a setting device (28) for setting (S07) the maximum discharge depth of the energy store for the second time period to the maximum discharge depth value $D_1$.

## Revendications

1. Procédé de réglage de la profondeur de décharge maximale d'un accumulateur d'énergie (10) pour une période, comprenant les étapes suivantes :

> définition (S01) d'une première valeur de vieillissement de consigne $a_{soll,1}$ de l'accumulateur d'énergie (10) pour une première période :

>> détermination (S02) d'une première valeur de vieillissement $a_1$ qui décrit un vieillissement de l'accumulateur d'énergie (10) pendant la première période ;
>> calcul (S03) d'une première différence $\Delta_1$ entre la première valeur de vieillissement de consigne $a_{soll,1}$ de l'accumulateur d'énergie (10) et la première valeur de vieillissement $a_1$ de l'accumulateur d'énergie (10) ;
>> définition (S04) d'une deuxième valeur de vieillissement de consigne $a_{soll,2}$ de l'accumulateur d'énergie (10) pour une deuxième période ;
>> détermination (S05) d'une valeur de vieillissement maximale $A_2$ de l'accumulateur d'énergie (10) pour la deuxième période en se basant sur la deuxième valeur de vieillissement de consigne $a_{soll,2}$ et au moins la première différence $\Delta_1$ ;
>> calcul (S06) d'une valeur de profondeur de décharge maximale $D_1$ basée sur la valeur de vieillissement maximale $A_2$ ;
>> réglage (S07) de la profondeur de décharge maximale de l'accumulateur d'énergie (10) pour la deuxième période à la valeur de profondeur de décharge maximale $D_1$.

2. Procédé selon la revendication 1, la première valeur de vieillissement de consigne $a_{soll,1}$ et la deuxième valeur de vieillissement de consigne $a_{soll,2}$ étant une valeur de vieillissement de consigne $a_{soll}$ globale constante.

3. Procédé selon la revendication 1, la première valeur de vieillissement de consigne $a_{soll,1}$ et/ou la deuxième valeur de vieillissement de consigne $a_{soll,1}$ étant réglées ou modifiées régulièrement en se basant sur une date du calendrier.

4. Procédé selon l'une des revendications précédentes 1 à 3, le procédé comprenant les étapes suivantes :

> détermination respective d'une profondeur de décharge de l'accumulateur d'énergie (10) pour tous les cycles de décharge pendant la première période ;
> la première valeur de vieillissement $a_1$ étant calculée en utilisant un modèle de vieillissement basé sur les profondeurs de décharge déterminées.

5. Procédé selon la revendication 4, la première valeur de vieillissement $a_1$ étant calculée en se basant sur une profondeur de décharge moyenne, la profondeur de décharge moyenne étant une valeur moyenne des profondeurs de décharge déterminées des cycles de décharge pendant la première période.

6. Procédé selon l'une des revendications précédentes 1 à 5, la deuxième période suivant directement la première période.

7. Procédé selon la revendication 6, le procédé étant mis en oeuvre pour chacune d'une pluralité de périodes qui se suivent directement en tant que deuxième période respective, la première valeur de vieillissement de consigne $a_{soll,1}$ correspondante de la première période étant la valeur de vieillissement maximale $A_1$ calculée (S05) pour la période respective qui précède directement.

8. Procédé selon l'une des revendications précédentes 1 à 7, une pluralité de différences $\Delta_i$ supplémentaires étant en outre calculée, chaque i-ème différence $\Delta_i$ étant une différence entre une i-ème valeur de vieillissement de consigne $a_{soll,1}$ de l'accumulateur d'énergie (10) et respectivement d'une i-ème valeur de vieillissement $a_i$ qui décrit un vieillissement de l'accumulateur d'énergie (10) pendant une i-ème période ; et
le calcul de la valeur de vieillissement maximale $A_2$ de l'accumulateur d'énergie (10) pour la deuxième période se basant en outre sur les différences $\Delta_i$ supplémentaires calculées.

9. Système de réglage d'une profondeur de décharge maximale d'un accumulateur d'énergie pour une période, comprenant :

> un dispositif de définition (22) destiné à définir (S01) une première valeur de vieillissement de consigne $a_{soll,1}$ de l'accumulateur d'énergie (10) pour une première période et définir (S04) une deuxième valeur de vieillissement de consigne $a_{soll,2}$ de l'accumulateur d'énergie (10) pour une deuxième période ;

un dispositif de détermination de valeur de vieillissement (24) destiné à déterminer (S02) une première valeur de vieillissement $a_1$ qui décrit un vieillissement de l'accumulateur d'énergie (10) pendant la première période ;

un dispositif de calcul (26) destiné à calculer (S03) une première différence $\Delta_1$ entre la première valeur de vieillissement de consigne $a_{soll,1}$ de l'accumulateur d'énergie (10) et la première valeur de vieillissement $a_1$ de l'accumulateur d'énergie (10), à calculer (S05) une valeur de vieillissement maximale $A_2$ de l'accumulateur d'énergie (10) pour la deuxième période en se basant sur la deuxième valeur de vieillissement de consigne $a_{soll,2}$ et au moins la première différence $\Delta_1$ et à calculer (S06) une valeur de profondeur de décharge maximale $D_1$ basée sur la valeur de vieillissement maximale $A_2$ ; et

un dispositif de réglage (28) destiné à régler (S07) la profondeur de décharge maximale de l'accumulateur d'énergie pour la deuxième période à la valeur de profondeur de décharge maximale $D_1$.

# Fig. 1

# Fig. 2

S01

S02

S03

S04

S05

S06

S07

**EP 3 058 615 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102007038586 A1